# EUROPEAN PATENT SPECIFICATION

(11) **EP 3 982 087 B1**
(45) Date of publication and mention of the grant of the patent: **05.10.2022**
(21) Application number: 20397513.1
(22) Date of filing: 09.10.2020
(51) Int. Cl.: G01D 4/00, G01R 22/06, G01D 21/00

(54) **AN ELECTRICITY METERING DEVICE**
STROMMESSVORRICHTUNG
DISPOSITIF DE MESURE D'ÉLECTRICITÉ

(43) Date of publication of application: 13.04.2022
(73) Proprietor: Aidon Oy, 40100 Jyväskylä (FI)
(72) Inventor: LOHVANSUU, Juha, 40720 Jyväskylä (FI)
(74) Representative: Berggren Oy

(56) References cited:
- EP-A2- 2 498 060
- US-A1- 2008 266 133

## Description

### Technical field

The present invention relates to an electricity metering device for monitoring electrical energy consumption.

### Background

Electricity consumption is commonly measured in individual units, such as households. The electricity network plays a critical role in modern societies. Nearly everything is run by Nicola Tesla's famous AC invention, although also DC solutions exist. Metering the usage of electric energy consumption plays a pivotal role. The accurate remote measurements and calculations of electric energy usage form the backbone of the present and future electric networks. Commonly the remotely readable electricity meters have a processor to perform the measurements and calculations.

Document EP2498060A2 presents systems, methods, and apparatuses for reducing network congestion in a smart utility meter system. The systems, methods, and apparatuses may include providing for a utility meter a first communications interface for communicating with a first network and providing for the utility meter a second communications interface for communicating with a second network different from the first network. The systems, methods, and apparatuses may include receiving or generating, by the utility meter, information having a destination. The systems, methods, and apparatuses may include selecting either the first communications interface or the second communications interface and delivering the information to the destination via the selected communications interface.

Document US2008/266133A1 presents a utility meter adapted to communicate with a device external to the utility meter. It comprises a meter housing, a first port, a second port and a processor. The first port is adapted to receive signals transmitted from outside the meter housing. The second port is connected to a communications module associated with the meter. The communications module is adapted to communicate with the device external to the utility meter. A processor is connected to the first port and the second port. The processor is configured to pass signals received at the first port to the communications module through the second port.

### Summary

Electricity metering forms the backbone of monitoring individual household electricity consumption. This metering is strictly regulated and must meet the demands of local authorities. These strict metering requirements have limited the development of other useful aspects that could be monitored while metering the consumption. One aim here is to provide versatile measurement data in addition to electricity consumption.

What is disclosed is described in the independent claims. According to an embodiment, an intelligent electricity metering device for metering electric power consumption comprises two sides, a mains side and an isolated side isolated from the mains side. The mains side includes the metering unit and the processing unit for accurate metering of the consumption that are regulated by the demands of the local authorities. The isolated side includes additional processing unit and communication unit for further processing and communication of the metered electricity data. There can be more than one processing unit on the isolated side. The mains side and the isolated side are digitally isolated from each other, but they are connected by two different interfaces. The first interface is bidirectional and connects the mains side processing unit to the processing unit(s) on the isolated side. The second interface is unidirectional and connects the mains side metering unit to the processing unit(s) on the isolated side. The second interface is a high speed raw data interface enabling rapid processing of any electricity data delivered from the mains side metering unit to the processing unit(s) on the isolated side.

Embodiments may enable, for example, rapid detection of local electric network irregularities in power delivery, faulty device diagnostics or arcs. State of the art does not recognize solutions combining the accurate metering of electricity consumption with integrated fast, seconds scale, detection and reactivity to local network irregularities or failures.

### Brief description of the drawings

- Figure 1: presents an exemplary block diagram of an electricity metering device for measuring electric power consumption.
- Figure 2: presents an exemplary block diagram of an electricity metering device for measuring electric power consumption with back-up power.
- Figure 3: presents an exemplary block diagram of a local load control in an electricity metering device.

### Detailed description

Metering of the electric energy consumption is commonly regulated by states or other authorized bodies. For example, in European Union the metering is governed by the Measuring Instrument Directive. Here, term MID interchangeably describes a functional or physical metering device part, side or entity that may be directly coupled to mains and follow the descriptions provided in the Measuring Instrument Directive, or any other official authority. Accordingly, the part which is not regulated in MID is termed GRID and interchangeably describes a functional or physical metering device part, side or entity that may be isolated from the mains. Electric energy consumption may be referred to as electric power consumption.

The metering device has a metering unit, which is arranged to convert analog signals to digital signals. Analog current and voltage signals may be converted to digital current and voltage signals, correspondingly. The metering unit is further arranged to filter and calculate electric power and energy data. The processing of the data occurs in two or more processing units. A first processing unit may be dedicated to the Measuring Instrument Directive, or any other official authority, required metering and determination of electric energy consumption. The first processing unit is digitally isolated, for example from the further one or more processing units. Thereby, MID metering and processing are "sealed" on to the mains side. This enables measuring basic electric energy consumption reliably and undisturbed on one processing unit, like the first processing unit dedicated to MID metering. Thereby, the first processing unit is dedicated for computational electric energy consumption processes that are officially required, for example based on directives or laws.

In this application Measuring Instrument Directive or other regulated metering may occur on the MID side. MID side may be called a mains side. In this application any other metering may occur on the GRID side. GRID side may be called an isolated side. The MID side is dedicated to the Measuring Instrument Directive, or any other official authority, required accurate electric power consumption metering. This metering and its processes are standardized. GRID side may be used for additional calculations and operations improving the function and reliability of the electric network.

A metering unit meters electric energy consumption and may provide data to a first processing unit. The first processing unit may provide processed and/or unprocessed data to one or more second processing unit(s) through a digitally isolated standard interface. The standard interface may be bi-directional and use a request-response protocol. The standard interface may be based on IEC 62956 set of standards. The speed of the standard interface may be 1-120000 bit/s, for example 9600 bit/s. A separate unidirectional streaming High Speed Raw Data Channel (HSRDC) may be an interface directly linking the metering unit to the second processing unit(s). The speed of the HSRDC interface may be, 1-80 Mbit/s, preferably 2-50 Mbit/s, even more preferably 5-10 Mbit/s. The first and the second end of the HSRDC may be digitally isolated from each other.

The metering unit may branch the metered electric energy consumption data to two or more data streams. One of the data streams may be a first data stream. The first data stream may be for the Measuring Instrument Directive, or any other official authority, required processing of the electricity consumption data. The first data stream may be based on IEC 62056 set of standards. The first data stream may be processed in the first processing unit. Other data stream(s) may be linked to second processing unit(s) via HSRDC. The second processing unit(s) may be multiprocessing unit(s). The other data streams may be used to analyse diagnostics additional to the Measuring Instrument Directive, or any other official authority, required metering. The additional diagnostics may be processed in the second processing unit(s). HSRDC enabled multiprocessing unit on the GRID side of the electricity metering device may include an integrated storage memory unit.

In an embodiment an electricity metering device with at least one HSRDC enabled multiprocessing unit on the GRID side may be used to employ Home Accuracy Verification (HAV) based electricity metering device verification directly in a Home Automation Network (HAN). The remote verification using the electricity metering device at consumer location may be based on encrypted digital ID tagging. For example, measurements of local electric energy consumption may be encrypted before transmission and they may be verified in the receiving end based on electricity meter specific ID. The ID may be tagged and followed. Individual electricity metering devices may be identified from a remote location, such as a substation in the electric power supply system, based on the specific loads and usage behaviour profiles of the individual electricity metering devices.

The remote calibration using the electricity metering device at consumer location may be based on external reference load. The remote calibration using the electricity metering device at the consumer location may be based on internal reference load. The remote calibration using the electricity metering device at the consumer location may be based on comparative reference load. The remote calibration using the electricity metering device at the consumer location may be based on any combination of reference loads selected from the group of internal, external and comparative reference loads.. According to an embodiment, the data in the HAV may be used to verify that the electricity metering device is working properly. The reference load may be arranged such that it is reliable and accurate. The external reference load may be, for example, a certified consumer electronics device with constant electric power consumption.

According to another embodiment, an electricity metering device with HSRDC enabled multiprocessing unit on the GRID side may be used to detect electric arc and/or risk of electric arc. The electricity metering device with HSRDC enabled multiprocessing unit on the GRID side may detect potential disturbances in the electric network, open circuits, weak connections and melted wirings by detecting arc by measuring harmonic current components. Harmonics is the generalised term that describes the distortion of a sinusoidal waveform by waveforms of different frequencies. Regardless of its shape, a complex waveform can be split up mathematically into its individual components: the fundamental frequency and a number of "harmonic frequencies". Current and voltage harmonics are generated due to nonlinear loads. Current harmonics are generated in the source side and the voltage harmonics are generated at output of nonlinear converters which output is AC or, for example, due to uneven generator design. In normal situation these harmonics attenuate towards higher frequencies. In arc fault situation these harmonics do not attenuate towards higher frequencies and this difference can be recognised. Such predictive and fast fault detection from all sockets would bring additional safety to homes. For example, the threat of old wirings melting or short circuiting increases as the number of electric cars and their home charging stations increases. Similarly, the charging of mobile gadgets in bed rooms increases the risk of fatal nocturnal fires. When device detects electric arc, the device may disconnect the house from the electric network using integrated circuit breaker and thus safe the house from burning. House owner can connect load back using push button. If arc still exists the alarm for electric arc is shown in display and reason for electric arc should be found. HSRDC with an interface or a channel speed of 1-80, preferably 2-50, even more preferably 5-10 Mbit/s coupled to a rapid processor(s) or multiprocessor(s) may be required to detect the harmonic current components.

According to yet another embodiment an electricity metering device with HSRDC enabled multiprocessing unit on the GRID side may be used to store electric power usage information. The electricity metering device with HSRDC enabled multiprocessing unit stored data may be used as a backup function. On the one hand such backup utility enables facilitating in fault detection and isolation. On the other hand the backup function enables facilitating the recovery of the electric network back to the state prior to the power failure.

In an embodiment the electricity metering device with HSRDC enabled multiprocessing unit on the GRID side may be embedded with additional external or integrated sensors, for example, but not limited to temperature, magnetic field or gas sensors. HSRDC enabled multiprocessing unit may be used to analyse the data from one or more additional sensors. This additional sensor information may be used to verify that the electricity metering device is connected correctly, for example, based on temperature inside the device. In addition, because temperature affects the life-time of electrical devices, additional sensor information may be used to estimate the life-time of the electricity metering device. Furthermore, the additional gas sensor information may be used to detect gaseous products formed by melting insulation, gas leaks or other fumes. The detection of different gases or change in the relative concentration of the gases may serve as an early indicator of a device malfunction, fire or other dangerous or life threatening situation.

These properties, like electric arc detection, consumption peaks, electric power monitoring, or other diagnostics related to the improved reliability and predictability of the electric network are realized by the HSRDC enabled multiprocessor unit on the GRID side in the local user premises, that is the user end, of the electric network. Local data processing suppresses delays within the electricity metering device, the temporal data stream queuing improves error tolerance due to local error only and enables faster reaction to errors. The temporal data stream queuing may be based on data buffer. The data buffer size may be determined based on desired error tolerance and/or one or more of the following requirements maximum acceptable pause, maximum acceptable down time or maximum acceptable reaction time.

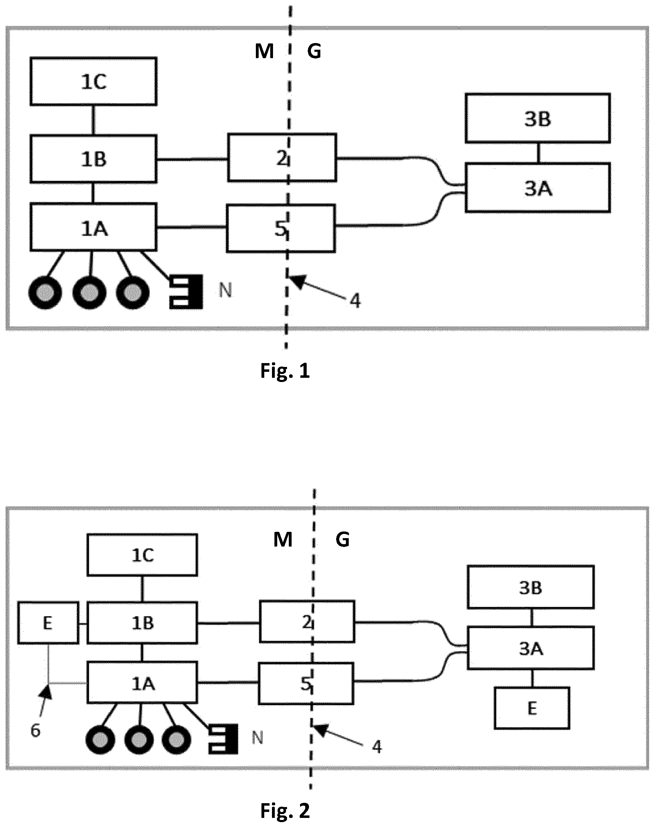

Figure 1 presents an exemplary block diagram of the electricity metering device measuring electric power consumption, where MID side M has a metering unit 1A that is arranged to convert first analog current and voltage signals to digital signals and then based on the digital signals filter and calculate accurate electric power and energy data, which is to be handled in a processing unit 1B. The processing unit 1B calculates energy consumption based on the electric power and energy data according to guidelines provided by the authorities, for example the Measuring Instrument Directive. The accuracy may be for example, max. 0.2 - 1 % deviation from the actual electric energy consumption. The processing unit 1B is arranged to show the electric energy consumption in the display 1C. The electric energy consumption may be used, for example, for billing purposes.

Due to remote reading requirements, the raw data from the metering unit 1A may be transmitted through a first interface 2 to a second processing unit 3A. The first interface 2 may be a two-way non-streaming, request-response communication standard interface with speed from 300 bit/s to 200 kbit/s. The first interface 2 may be based on IEC 62056 set of standards. The second processing unit 3A may operate a communication unit 3B, which may be, for example, an LTE modem. The second processing unit 3A and the communication unit 3B may be isolated 4 from the mains side M using digital isolators in the first interface 2.

According to an embodiment the invention, as presented in the figure 1, a second interface 5 connects the metering unit 1A to the second processing unit 3A. The second processing unit 3A may be a multiprocessing unit. The second processing unit 3A may contain a plurality of individual multiprocessing units. The second interface 5 may be arranged to transfer raw data at high speed, for example 1- 40 Mbit/s, from the metering unit 1A at mains side M to the second processing unit at the isolated side G. The second interface 5 may be HSRDC. Unidirectional streaming high speed raw data may be used in the second processing unit 3A to calculate phenomena which processing unit 1B cannot calculate. Inability of the processing unit 1B may be due to filtering implemented in the measurement unit 1A, which is arranged in order to get accurate measurements according to guidelines provided by the authorities, for example the Measuring Instrument Directive. The standardized 1A and 1B on the mains side M are standardized bidirectional request-response protocol type of solutions that cannot be used for tasks that require streaming or continuous data with high sampling rate.

According to an embodiment the invention, the first interface 2 may be a standard bidirectional interface that can only connect to one unit or device on either side of the interface. According to an embodiment of the invention, the second interface 5 may be a unidirectional streaming raw data interface that can connect to multiple HSRDC enabled processors on the GRID side G.

According to an aspect of the invention, the technological requirements for metrologically relevant processing unit 1B may be reduced or maintained, because the second interface 5 and the second processing unit 3A may be used for calculations not required by the Measuring Instrument Directive or any other official authority. The second interface 5 and the second processing unit 3A may be additionally used to perform, repeat or redo Measuring Instrument Directive required calculations, or calculations required by any other official authority, also performed by processing unit 1B. According to an aspect of the invention, the performance requirements for the first interface handling the data between processing units 1B and 3A may be reduced or maintained, because the second interface 5 and the second processing unit 3A may be used for calculations not required by the Measuring Instrument Directive or any other official authority. The second interface 5 and the second processing unit 3A may be additionally used to perform, repeat or redo Measuring Instrument Directive required calculations, or calculations required by any other official authority, also performed by processing unit 1B.

When HSRDC is implemented as unidirectional streaming data, the HSRDC on the GRID side G has no influence to the MID side M metering, as the GRID side G is only listening to the data. All the bidirectional data exchange back to the MID side M may be operated through the standard first interface 2. Any information required from the metering unit 1A to pass through the second interface 5 to the second processing unit 3A may be initiated by the standard interface first. After this initiation, activation and deactivation of the data streaming through the second interface 5 from the metering device 1A to the second processing unit 3A may be controlled by the first processing unit 1B. The activation or initiation may be controlled from the GRID side G communication unit 3B.

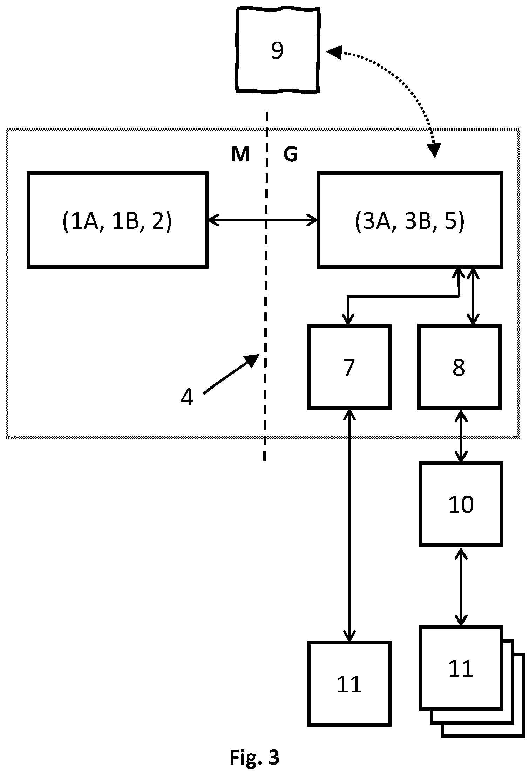

According to an embodiment shown in figure 2, an electricity metering device with HSRDC enabled multiprocessing unit on the GRID side G may be implemented with reserve or back-up power E. The back-up power E and backup power functionality may provide back-up power to clock function, processor function, a metering unit 1A via control interface 6 and/or calculations performed by the first processing unit 1B and/or the second processing unit 3A via the first interface 2 and/or the second interface 5. Using the information, for example, but not limited to peak current and voltage, measured during the power down, fast reconnection and time reconnection may be delivered to adjacent system using back-up power E. The adjacent system 9 in figure 3 may locate the fault position and in that way, isolation of faulty area from electric network may be faster and more precise and more households may get their electricity back earlier than with the traditional manual fault isolation, test and fail reconnection process. With enhanced process, only nearest possible place for isolation needs to be activated or, in an optimal case, no isolation is needed due easy fix of the fault.

According to an embodiment the raw data streamed to the second processing unit 3A by the unidirectional HSRDC second interface 5 may be used to monitor frequency control and load of the electric network in real-time. The use of the second processing unit 3A to calculate streaming frequency and load may enable the seconds timescale response of the intelligent electricity metering device to rapid load changes in the electric network. Such rapid changes in the electric network may be caused by error situations or changes in the production of renewable energy. According to the embodiments the rapid response of the intelligent electricity metering device may be a controlled reduction of local electric power consumption and electric network load in order to compensate for the reduced electric power production or delivery of the electric network. The second interface 5 and the second processing unit 3A of the GRID side G of the intelligent electricity metering device may be used as raw data frequency control triggers.

Figure 3 presents an exemplary block diagram of a local load control in an electricity metering device and thus presents an embodiment with local load control directly on site. An electricity metering device according to embodiments M, G, may be equipped with a dedicated load control relay 7. Alternatively, it may utilise a home area network (HAN) interface 8 connected to an HAN device 10 in order to provide load control commands. This may reduce temporal delays because decision making is done locally. There is no need for hand-shakes or other verification steps compared to situation where decision making is done on a system level 9 (on premise or in a cloud service). The electricity metering device M, G may be equipped with its own load control relay 7 to control the load 11. If there are more than one controllable loads 11 in different places, the HAN device 10 may handle the load control based on information given by the HAN interface 8. The HAN device 10 may use instantaneous, real-time, electric power consumption data acquired from the second interface 5 and transmitted via the HAN interface 8. The HAN device 10 may enable rapid reacting, in seconds timescale, to changes in the state of the electric network block handled by the electricity device of the embodiments. Processing unit 3A may observe the instantaneous, real-time, effects of the reactions and determine the adequacy of the changes in the electric power consumption. Using the HSRDC enabled multiprocessing unit on the GRID side G with streaming data may reduce time delays to 1- 30 seconds compared to 15 minute MID side M metering intervals. The streaming data from the GRID side G related to electric network power drop, drop related frequency control actions and reporting of the action efficiency may be grouped into a single information package towards system 9 and benefits of the wanted load changes may be shared to right participants.

According to another embodiment, fast streaming data provided by the HSRDC and HSRDC enabled multiprocessing unit on the GRID side may be used to identify customer loads in general. The data may be used not only to detect and measure the accuracy verification related loads but also to evaluate the end user's potential to participate in demand management and demand response based solutions. These solutions may, for example, be related to the frequency based features of the electric network as described earlier. Since the solution is on the GRID side, any detection algorithms and parameters may be safely added and changed without having any influence on the accuracy demanding metering on the MID side of the electricity metering device.

According to the embodiment, reliable and accurate real-time load registration may be used to load balancing based on variations in energy production and changes in weather. For example, energy production with renewable energy sources, such as wind power or solar power, may cause variations in the overall load in the electric network.

According to yet another embodiment, high speed sampling may be used to produce measurement logger features. When more and more electrical devices are coupled into electric network, the likelihood of problems with aging devices grow. There will be an increasing number of cases where one device may slow down or disturb another device. Sometimes these kinds of interference phenomena last only parts of seconds and collecting all short samples from all the meters all the time is very costly. The more efficient way may be to use the high speed sampling enabled by the HSRDC enabled multiprocessing unit on the GRID side to detect trigger values based on measurements and collect them as a log or a record of short samples. Thereafter, these records may be collected to a reading system for further analyses.

As indicated be the figures and the text, the MID side and the GRID side, with all the described functional entities, including at least a metering unit, a standard data channel, a high speed data channel, digital isolation between MID side and GRID side, one or more processing units and a communication unit may be integrated into a single electricity metering device. In addition, at least one sensor, internal backup power supply and any computational arrangements performed by the computational units, for example to improve local electric network reliability and functionality by monitoring and/or controlling local load, detecting arc, logging peak or interference activity, and/or storing peak or interference activity, may be integrated into the electricity metering device.

In summary, the first processing unit may focus mainly for precise electric power consumption metering, for example, for billing data and correctness of billing thus increasing the reliability and general trust towards the metering. The second processing unit(s) may be used for more time critical applications like frequency based load controls, network quality measurements, fingerprint finding and fault position detection in the electric network. The more information from different phenomena can be collected from electric network, the better action can be taken to secure efficient operation of the electric network.

## Claims

1. An electricity metering device for metering electric power consumption comprising
- a mains side (M) including
- a metering unit (1A), connected to
- a first processing unit (1B),
- an isolated side (G) including
- a second processing unit (3A), connected to
- a communication unit (3B),
- wherein the mains side (M) and the isolated side (G) are digitally isolated (4) from each other, and
- the first processing unit (1B) is connected to the second processing unit (3A) by a first interface (2),
- the metering unit (1A) is connected to the second processing unit (3A) by a second interface (5).

2. An electricity metering device in accordance with claim 1, wherein the metering unit (1A) is arranged to convert analog current and voltage signals to digital current and voltage signals, and the metering unit (1A) is arranged to filter and calculate accurate electric power and energy data based on the converted current and voltage signals.

3. An electricity metering device in accordance with claims 1 and 2, comprising a display (1C) connected to the first processing unit (1B).

4. An electricity metering device in accordance with any of the preceding claims, wherein the first interface (2) is arranged to transfer data metered by the metering unit (1A) and processed by the first processing unit (1B) from the first processing unit (1B) to the second processing unit (3A).

5. An electricity metering device in accordance with any of the preceding claims, wherein the second interface (5) is arranged to transfer raw data from the metering unit (1A) to the second processing unit (3A).

6. An electricity metering device in accordance with any of the preceding claims, wherein the isolated side includes two or more processing units (3A).

7. An electricity metering device in accordance with any of the preceding claims, comprising a back-up power module (E) connected to at least one of the metering unit (1A), the first processing unit (1B) and the second processing unit (3A) arranged to provide power for the electricity metering device during power down

8. An electricity metering device in accordance with any of the preceding claims, comprising the first interface (2) arranged to operate on speed level of kbit/s two-directional request-response protocol data and the second interface (5) arranged to operate on speed level of Mbit/s, or higher, unidirectional streaming data.

9. An electricity metering device in accordance with any of claims 5-8, wherein the second processing unit (3A), based on the raw data provided to it from measuring unit (1A), is arranged to locally control the current load (11) of the electric system.

10. An electricity metering device in accordance with any of claims 5-9, wherein the second processing unit (3A), based on the raw data provided to it from measuring unit (1A), is arranged to locally control the current load (11) of the electric system with less than 15 seconds delay.

11. An electricity metering device in accordance with any of claims 5-10, wherein the second processing unit (3A), based on the raw data provided to it from measuring unit (1A), is arranged to detect electric arc based on equal harmonic current components.

12. An electricity metering device in accordance with any of claims 5-11, wherein the second processing unit (3A), based on the raw data provided to it from measuring unit (1A), is arranged to evaluate the end user's potential to participate in demand management and demand response of the electric network.

13. An electricity metering device in accordance with any of claims 5-12, wherein the second processing unit (3A), based on the raw data provided to it from measuring unit (1A), is arranged to
- detect trigger values based on metering,
- collect the detected trigger values as a log or a record of short samples, and
- store the log and/or records for further analyses.

14. An electricity metering device in accordance with any of claims 5-13, wherein the second processing unit (3A), based on the raw data provided to it from measuring unit (1A), is arranged to store data on electric power usage, wherein the stored data is used as a backup function.

15. An electricity metering device in accordance with any of claims 5-14, wherein the processing unit (3A) is arranged to implement diagnostics based on the raw data provided to it from measuring unit (1A), the diagnostics optionally including at least one of arc detection, consumption peaks detection and electric power monitoring.

## Patentansprüche

1. Strommessvorrichtung zum Messen des Stromverbrauchs umfassend
- eine Netzseite (M) umfassend
- eine Messeinheit (1A), die mit folgenden verbunden ist:
- eine erste Verarbeitungseinheit (1B),
- eine isolierte Seite (G) umfassend
- eine zweite Verarbeitungseinheit (3A), die mit folgenden verbunden ist:
- eine Kommunikationseinheit (3B),
- wobei die Netzseite (M) und die isolierte Seite (G) digital voneinander getrennt (4) sind, und
- die erste Verarbeitungseinheit (1B) über eine erste Schnittstelle (2) mit der zweiten Verarbeitungseinheit (3A) verbunden ist,
- die Messeinheit (1A) über eine zweite Schnittstelle (5) mit der zweiten Verarbeitungseinheit (3A) verbunden ist.

2. Strommessvorrichtung nach Anspruch 1, wobei die Messeinheit (1A) eingerichtet ist, um analoge Stromund Spannungssignale in digitale Strom- und Spannungssignale umzuwandeln, und die Messeinheit (1A) angeordnet ist, um genaue elektrische Leistungs- und Energiedaten basierend auf den umgewandelten Strom- und Spannungssignalen zu filtern und zu berechnen.

3. Strommessvorrichtung nach Anspruch 1 und 2, umfassend eine Anzeige (1C), die mit der ersten Verarbeitungseinheit (1B) verbunden ist.

4. Strommessvorrichtung nach einem der vorhergehenden Ansprüche, wobei die erste Schnittstelle (2) angeordnet ist, um von der Messeinheit (1A) gemessene und von der ersten Verarbeitungseinheit (1B) verarbeitete Daten von der ersten Verarbeitungseinheit (1B) an die zweite Verarbeitungseinheit (3A) zu übertragen.

5. Strommessvorrichtung nach einem der vorhergehenden Ansprüche, wobei die zweite Schnittstelle (5) eingerichtet ist, Rohdaten von der Messeinheit (1A) an die zweite Verarbeitungseinheit (3A) zu übertragen.

6. Strommessvorrichtung nach einem der vorhergehenden Ansprüche, wobei die isolierte Seite zwei oder mehr Verarbeitungseinheiten (3A) enthält.

7. Strommessvorrichtung nach einem der vorangehenden Ansprüche, umfassend ein Notstrommodul (E), das mit mindestens einer der Messeinheiten (1A) verbunden ist, wobei die erste Verarbeitungseinheit (1B) und die zweite Verarbeitungseinheit (3A) so angeordnet sind, dass sie Strom für die Strommessvorrichtung während Stromabschaltung bereitstellen.

8. Strommessvorrichtung nach einem der vorhergehenden Ansprüche, umfassend die erste Schnittstelle (2), die eingerichtet ist, um auf einem Geschwindigkeitsniveau von kbit/s-Zweirichtungs-Anfrage-Antwort-Protokolldaten zu arbeiten, und die zweite Schnittstelle (5), die eingerichtet ist, um auf einem Geschwindigkeitsniveau von Mbit/s oder höher, unidirektionalen Streaming-Daten zu arbeiten.

9. Strommessvorrichtung nach einem der Ansprüche 5 bis 8, wobei die zweite Verarbeitungseinheit (3A) angeordnet ist, um die Stromlast (11) des elektrischen Systems basierend auf den ihr von der Messeinheit (1A) bereitgestellten Rohdaten lokal zu steuern.

10. Strommessvorrichtung nach einem der Ansprüche 5 bis 9, wobei die zweite Verarbeitungseinheit (3A) angeordnet ist, um die Stromlast (11) des elektrischen Systems basierend auf den ihr von der Messeinheit (1A) bereitgestellten Rohdaten mit weniger als 15 Sekunden Verzögerung lokal zu steuern.

11. Strommessvorrichtung nach einem der Ansprüche 5 bis 10, wobei die zweite Verarbeitungseinheit (3A) so angeordnet ist, dass sie einen Lichtbogen auf der Grundlage gleicher harmonischer Stromkomponenten basierend auf den ihr von der Messeinheit (1A) bereitgestellten Rohdaten erkennt.

12. Strommessvorrichtung nach einem der Ansprüche 5 bis 11, wobei die zweite Verarbeitungseinheit (3A) so angeordnet ist, dass sie das Potenzial des Endbenutzers zur Teilnahme am Bedarfsmanagement und Bedarfssteuerung des Stromnetzes basierend auf den ihr von der Messeinheit (1A) bereitgestellten Rohdaten bewertet.

13. Strommessvorrichtung nach einem der Ansprüche 5 bis 12, wobei die zweite Verarbeitungseinheit (3A) dazu eingerichtet ist, um basierend auf den ihr von der Messeinheit (1A) bereitgestellten Rohdaten
- Auslösewerte anhand der Messung zu erkennen,
- die erkannten Auslösewerte als Protokoll oder Aufzeichnung kurzer Stichproben zu sammeln, und
- Protokoll und/oder Aufzeichnungen für weitere Analysen zu speichern.

14. Strommessvorrichtung nach einem der Ansprüche 5 bis 13, wobei die zweite Verarbeitungseinheit (3A) angeordnet ist, um Daten über den Stromverbrauch basierend auf den ihr von der Messeinheit (1A) bereitgestellten Rohdaten zu speichern, wobei die gespeicherten Daten als Sicherungsfunktion verwendet werden.

15. Strommessvorrichtung nach einem der Ansprüche 5 bis 14, wobei die Verarbeitungseinheit (3A) angeordnet ist, um eine Diagnose basierend auf den ihr von der Messeinheit (1A) bereitgestellten Rohdaten zu implementieren, wobei die Diagnose optional mindestens eines von Lichtbogenerkennung, Verbrauchsspitzenerkennung und Überwachung der elektrischen Energie umfasst.

## Revendications

1. **Dispositif de mesure d'électricité pour mesurer la consommation d'alimentation électrique comprenant**
- un côté réseau (M) comportant
- une unité de mesure (1A), connectée à
- une première unité de traitement (1B),
- un côté isolé (G) comportant
- une seconde unité de traitement (3A), connectée à
- une unité de communication (3B),
- dans lequel le côté réseau (M) et le côté isolé **(G) sont isolés numériquement (4) l'un de l'autre, et**
- la première unité de traitement (1B) est connectée à la seconde unité de traitement (3A) par une première interface (2),
- **l'unité de** mesure (1A) est connectée à la seconde unité de traitement (3A) par une seconde interface (5).

2. **Dispositif de mesure d'électricité** selon la revendication **1, dans lequel l'uni**té de mesure (1A) est disposée pour convertir des signaux analogiques de courant et de tension en signaux numériques de courant **et de tension, et l'unité de** mesure (1A) est disposée pour filtrer et calculer des données précises sur **l'alimentation et l'éner**gie électriques sur la base des signaux de courant et de tension convertis.

3. **Dispositif de mesure d'électricité conformément aux** revendications 1 et 2, comprenant un écran (1C) connecté à la première unité de traitement (1B).

4. **Dispositif de mesure d'électricité** selon **l'une** quelconque des revendications précédentes, dans lequel la première interface (2) est disposée pour transférer **des données mesurées par l'unité de** mesure (1A) et traitées par la première unité de traitement (1B) depuis la première unité de traitement (1B) vers la seconde unité de traitement (3A).

5. **Dispositif de mesure d'électricité** selon **l'une** quelconque des revendications précédentes, dans lequel la seconde interface (5) est disposée pour transférer des **données brutes depuis l'unité de** mesure (1A) vers la seconde unité de traitement (3A).

6. **Dispositif de mesure d'électricité** selon **l'une** quelconque des revendications précédentes, dans lequel le côté isolé comporte deux unités de traitement ou plus (3A).

7. **Dispositif de mesure d'électricité** selon **l'une** quelconque des revendications précédentes, comprenant un **module d'alimentation de secours** (E) connecté à au moins **l'une de l'**une unité de mesure (1A), la première unité de traitement (1B) et la seconde unité de traitement (3A) disposées de manière à fournir une alimentation pour le **dispositif de mesure d'électricité lors de la mise hors** tension.

8. **Dispositif de mesure d'électricité** selon **l'une** quelconque des revendications précédentes, comprenant la première interface (2) disposée pour commander un niveau de vitesse en kbit/s de données de protocole de demanderéponse bidirectionnelles et la seconde interface (5) disposée pour commander un niveau de vitesse en Mbit/s, ou plus, de données de diffusion unidirectionnelle.

9. **Dispositif de mesure d'électricité** selon **l'une** quelconque des revendications 5 à 8, dans lequel la seconde unité de traitement (3A), sur la base des données **brutes qui lui sont fournies par l'unité de** mesure (1A), est disposée de manière à réguler localement la charge de courant (11) du système électrique.

10. **Dispositif de mesure d'électricité** selon **l'une** quelconque des revendications 5 à 9, dans lequel la seconde unité de traitement (3A), sur la base des données **brutes qui lui sont fournies par l'unité de** mesure (1A), est disposée de manière à réguler localement la charge de courant (11) du système électrique avec un délai inférieur à 15 secondes.

11. **Dispositif de mesure d'électricité** selon **l'une** quelconque des revendications 5 à 10, dans lequel la seconde unité de traitement (3A), sur la base des données **brutes qui lui sont fournies par l'unité de** mesure (1A), est disposée pour détecter un arc électrique sur la base de composants de courant harmonique égaux.

12. **Dispositif de mesure d'électricité** selon **l'une** quelconque des revendications 5 à 11, dans lequel la seconde unité de traitement (3A), sur la base des données brutes qui lui sont four**nies par l'unité de** mesure (1A), **est disposée pour évaluer le potentiel de l'utilisateur** final à participer à la gestion de la demande et à la réponse de la demande du réseau électrique.

13. **Dispositif de mesure d'électricité** selon **l'une** quelconque des revendications 5 à 12, dans lequel la seconde unité de traitement (3A), sur la base des données **brutes qui lui sont fournies par l'unité de** mesure (1A), est disposée pour
- détecter des valeurs de déclenchement sur la base des mesures,
- collecter les valeurs de déclenchement **détectées sous forme de journal ou d'**un enregistrement **d'échantillons courts, et**
- stocker le journal et/ou les enregistrements pour des analyses ultérieures.

14. **Dispositif de mesure d'électricité** selon **l'une** quelconque des revendications 5 à 13, dans lequel la seconde unité de traitement (3A), sur la base des données **brutes qui lui sont fournies par l'unité de** mesure (1A), **est disposée pour stocker des données sur l'usage de l'alimentation électrique, les données stockées étant** utilisées comme fonction de secours.

15. **Dispositif de mesure d'électricité** selon **l'une** quelconque des revendications 5 à 14, dans lequel **l'unité de traitement (3A) est disposée pour mettre en œuvre des diagnostics sur la base des données brutes qui lui sont fournies par l'uni**té de mesure (1A), les diagnostics comportant éventuellement au moins l'une de la **détection d'arc, la détection de pics de consommation et la surveillance de l'alimentation électrique.**
